# EUROPÄISCHE PATENTANMELDUNG

(11) **EP 2 731 412 A2**
(43) Veröffentlichungstag der Anmeldung: **14.05.2014**
(21) Anmeldenummer: 13192553.9
(22) Anmeldetag: 12.11.2013
(51) Int. Cl.: H05K 5/06, A47C 31/00

(54) **Gehäuse mit mindestens zwei Gehäuseteilen und einem Dichtelement**

(30) Priorität: 13.11.2012 DE 202012104371 U
(71) Anmelder: DewertOkin GmbH, 32278 Kirchlengern (DE)
(72) Erfinder: Klimm, Hartmut, 32257 Bünde (DE)
(74) Vertreter: Kleine, Hubertus

(57) **Zusammenfassung**

Die Erfindung betrifft ein Gehäuse zur Aufnahme von mechanischen und/oder elektrischen Komponenten eines elektromotorischen Möbelantriebs mit mindestens zwei Gehäuseteilen (11, 12) und einem Dichtelement (14), welches zwischen einander zugewandten Stoßflächen der mindestens zwei Gehäuseteile (11, 12) angeordnet ist. Das Gehäuse zeichnet sich dadurch aus, dass das Dichtelement (14) einen Steg (15) aufweist, welcher zwischen den Stoßflächen nach außen zu einer äußeren Gehäusekante (19) geführt ist und außerhalb des Gehäuses einen Fortsatz (16) aufweist, welcher als Stoßabsorber (13) ausgebildet ist.

## Beschreibung

Die Erfindung betrifft ein Gehäuse zur Aufnahme von mechanischen und/oder elektrischen Komponenten eines elektromotorischen Möbelantriebs mit mindestens zwei Gehäuseteilen und einem Dichtelement, welches zwischen einander zugewandten Stoßflächen der mindestens zwei Gehäuseteile angeordnet ist

Derartige Gehäuse mit einem Dichtelement sind aus dem Stand der Technik bekannt, wobei das Dichtelement zwischen den Stoßflächen der einzelnen Gehäuseteile angeordnet ist und gegen ein Eindringen von Staub oder Flüssigkeit in das Gehäuseinnere abdichten soll. Dabei weist wenigstens ein Gehäuseteil im Bereich der Stoßfläche z.B. eine umlaufende Nut auf, in welche das Dichtelement eingesetzt ist.

Solche Gehäuse werden beispielsweise bei Handbedienungen von elektromotorischen Möbelantrieben eingesetzt. In einem solchen Anwendungsfall bestehen erhöhte mechanische Anforderungen an die Abdichtung und an die Gehäuseteile. Sie müssen so konzipiert sein, dass sie ein mehrfaches Herunterfallen unbeschadet und ohne Einbußen der Abdichtung überstehen können. Derartige Gehäuse genießen somit ein erhöhtes Maß an Robustheit, indem sie aus speziellem Material gefertigt sind und/oder dickwandiger hergestellt sind. Das führt aber wiederum zu einer Gewichtszunahme und zu einem erhöhten Materialeinsatz. Aus dem Grund ist man dazu übergegangen, dünnwandige Gehäuse mit einem umspannenden Gummirahmen zu versehen. Sofern ein derartiger Gummirahmen als separates Bauteil über das Gehäuse, ein Gehäuse einer Handbedienung für den Pflege- oder Hospitalbereich, gestülpt wird, wirkt sich dies negativ auf die Reinigung aus. Sofern ein derartiger Gummirahmen als stoffschlüssige Verbindung mit einem Gehäuseteil verbunden ist, steigen die Fertigungskosten stark.

Der Erfindung liegt somit die Aufgabe zugrunde, ein Gehäuse bestehend aus Gehäuseteilen mit einem Dichtelement zu schaffen, welches die o.g. Nachteile nicht mehr aufweist, leicht in der Montage ist, wobei eine leichte und gründliche Reinigung des Hüllgehäuses gewährleistet werden kann und wobei das Eigengewicht in Relation zur Robustheit idealisiert ist.

Erfindungsgemäß wird diese Aufgabe durch ein Gehäuse mit den Merkmalen des unabhängigen Anspruchs gelöst. Vorteilhafte Ausgestaltungen und Weiterbildungen sind in den abhängigen Ansprüchen angegeben.

Bei einem erfindungsgemäßen Gehäuse der eingangs genannten Art weist das Dichtelement einen Steg auf, welcher zwischen den Stoßflächen nach außen zu einer äußeren Gehäusekante geführt ist und außerhalb des Gehäuses einen Fortsatz aufweist, welcher als Stoßabsorber ausgebildet ist.

Das Gehäuse ist aus wenigstens zwei Gehäuseteilen gebildet. Die Gehäuseteile sind beispielsweise im Spritzgießverfahren oder im Druckgussverfahren aus einem Kunststoff oder aus einem Metall hergestellt. Bei den Gehäuseteilen handelt es sich üblicherweise um räumlich gestaltete Bauteile, welche schalenartig konzipiert sind.

Das Gehäuse kann beispielsweise als Hüllgehäuses zur Aufnahme von mechanischen und/oder elektrischen Komponenten eines elektromotorischen Möbelantriebs konzipiert sein.

In einer vorteilhaften Ausführungsform eines Gehäuses bzw. eines Hüllgehäuses einer Komponente eines elektromotorischen Möbelantriebs ist in dem Hüllgehäuse wenigstens ein Elektromotor angeordnet, dem eine Getriebekette mit einem beweglichen Abtriebsglied nachgeschaltet ist. Dabei ist das bewegliche Abtriebsglied mit einem Möbelbauteil gekoppelt, wobei sich bei Betrieb des Elektromotors das mit dem Abtriebsglied gekoppelte Möbelbauteil relativ zu einem weiteren Möbelbauteil bewegt.

In einer anderen Ausführungsform eines Gehäuses bzw. eines Hüllgehäuses einer Komponente eines elektromotorischen Möbelantriebs ist in dem Hüllgehäuse eine Energieversorgung angeordnet. Diese kann als netzunabhängige Energieversorgung wie Batterie oder Akkumulator ausgebildet sein. Eine netzgebundene Energieversorgung weist einen Trenntransformator oder einem Übertrager mit einer Primärseite und einer Sekundärseite auf, wobei die Primärseite mit elektrischer Energie eines Energieversorgers beaufschlagbar ist.

Bei einer weiteren und bevorzugten Ausführungsform eines Gehäuses bzw. eines Hüllgehäuses einer Komponente eines elektromotorischen Möbelantriebs weist das Hüllgehäuse Tastbedienelemente zum Schalten und zum Bedienen wenigstens eines Elektromotors des elektromotorischen Möbelantriebs auf. Die Tastbedienelemente sind mit elektrischen Schaltern im Inneren des Hüllgehäuses gekoppelt, so dass bei Tastendruck ein elektrischer Schaltkreis zur Bedienung bzw. zum Steuern wenigstens eines Elektromotors des Möbelantriebs betätigt bzw. geschlossen wird. Dabei kann der jeweilige elektrische Schalter als Steuerschalter ausgebildet sein und ist in einem Steuerschaltkreis beispielsweise zur Ansteuerung eines Relais oder eines Transistors angeordnet. Alternativ ist der jeweilige elektrische Schalter als Lastschalter ausgebildet und ist in einem Schaltkreis mit einem elektrischen Verbraucher angeordnet. Als elektrische Verbraucher kommen Elektromotoren mit einer nachgeschalteten Getriebekette (wie oben erwähnt mit einem gekoppelten Abtriebsglied zum Bewegen von gekoppelten Möbelbauteilen relativ zueinander), Massageeinheiten, Massagemotoren, Heizungen in Frage.

Dem Gehäuse ist ferner ein Dichtelement zugewiesen, welches sich zwischen zwei angrenzenden Gehäuseteilen, somit zwischen den einander zugewandten Stoßflächen der Gehäuseteile, befindet. Das Dichtelement kann glattflächig ausgebildet sein oder es kann glattflächige Abschnitte aufweisen. Alternativ weist das Dichtelement Vorsprünge auf. Die Vorsprünge greifen bevorzugt in Ausnehmungen des jeweiligen Gehäuseteils ein und bilden eine Art eines Labyrinths, um die Dichtigkeit zu erhöhen und/oder das Dichtelement am Gehäuse festzulegen.

Erfindungsgemäß weist das Dichtelement einen Steg auf, welcher zwischen den Gehäuseteilen angeordnet ist und zur äußeren Gehäusekante des Hüllgehäuses geführt ist. Außerhalb des Hüllgehäuses weist der Steg des Dichtelements einen Fortsatz auf. Der Fortsatz weist beispielsweise wenigstens eine Länge von 1 Millimeter bis maximal 10 Millimeter auf.

Der Fortsatz selbst kann im Querschnitt betrachtet unterschiedlich ausgebildet sein. So ist er gemäß einer Ausführung querschnittsgleich oder querschnittsähnlich mit dem Steg. Alternativ ist der Fortsatz schmaler als der Steg ausgebildet. Alternativ ist der Fortsatz deutlich breiter als der Steg ausgebildet und erstreckt sich über Bereiche des äußeren Hüllgehäuses, beispielsweise in einem Bereich von bis zu 30 Millimetern über der äußeren Manteloberfläche wenigstens eines Gehäuseteils. Gemäß einer bevorzugten Ausführungsform ist der Fortsatz im Querschnitt gesehen wenige Millimeter breit und wenige Millimeter hoch bezogen auf die Mittellängsahse des Steges.

In jeder der vorgenannten Ausführungsformen des Fortsatzes ist dieser als Stoßabsorber ausgeführt. In einer Ausgestaltung sind sowohl der Fortsatz, der Steg als auch das Dichtelement als einstückiges Formteil aus einem Elastomer gebildet. Der Vorteil der einstückigen Ausbildung liegt darin, dass sich ein Stoßimpuls, welcher von dem Fortsatz bzw. von dem Stoßabsorber aufgenommen wird, zumindest anteilig über den Steg und das Dichtelement großflächig auf die Stoßflächen der Gehäuseteile verteilt werden, so dass ein großer Stoßimpuls eine nur sehr geringe mechanische Auswirkung auf das Gehäuse hat. Ein weiterer Vorteil liegt in der einfachen Montage des Gehäuses. Ist der Fortsatz bzw. der Stoßabsorber breiter als der Steg ausgebildet, so überdeckt der Stoßabsorber zumindest ein Gehäuseteil flächig und bei Auftreten eines großen Stoßimpulses wird dieser zusätzlich auf die Außenhaut bzw. auf die äußere Manteloberfläche des Gehäuses übertragen.

Eine Verbindung der Gehäuseteile kann durch verschiedene Verbindungsmittel erfolgen, beispielsweise durch eine Verschraubung, für die entsprechende Schraubdome in die Gehäuseteile eingearbeitet sind, oder mittels einer Verrastung, die über geeignete, ebenfalls in die Gehäuseteile eingearbeitete und ineinander eingreifende Rastmittel, z.B. Rasthaken.

In einer weiteren vorteilhaften Ausgestaltung sind die beiden Gehäuseteile miteinander stoffschlüssig verbunden, bevorzugt durch mindestens eine Ultraschallschweißnaht. Dabei kann die Ultraschallschweißnaht entlang von Gehäusestegen geführt sein, wobei die Gehäusestege in den Gehäuseteilen benachbart zu den Stoßflächen, zwischen denen der Steg angeordnet ist, ausgebildet sind. Alternativ ist es auch möglich, die Gehäuseteile über den Steg miteinander zu verbinden, wobei jedes der beiden Gehäuseteile mit mindestens je einer Ultraschallschweißnaht mit dem Steg verbunden ist. Die Ultraschallschweißnähte ermöglichen eine stabile und gleichzeitig abdichtende Verbindung der beiden Gehäuseteile, die mit geringem Montageaufwand gut automatisierbar im Herstellungsprozess umgesetzt werden kann. Als Ultraschallschweißnaht ist im Rahmen der Anmeldung eine durchgängige Naht ebenso zu verstehen wie eine Mehrzahl von Schweißnahtabschnitten oder auch eine Kette von einzelnen Schweißungen.

Die Erfindung wird nachfolgend anhand von Ausführungsbeispielen mithilfe von Figuren näher erläutert. Es zeigen:
- Figur 1: eine räumliche Darstellung einer Handbedienung eines elektromotorischen Möbelantriebs;
- Figur 2: einen Detailschnitt eines Schnitts durch das Gehäuse im Bereich der Dichtung nach Figur 1 in einer ersten Ausführung; und
- Figuren 3 bis 5: jeweils ein Detailschnitt eines Schnitts durch das Gehäuse im Bereich der Dichtung nach Figur 1 in weiteren Ausführungen.

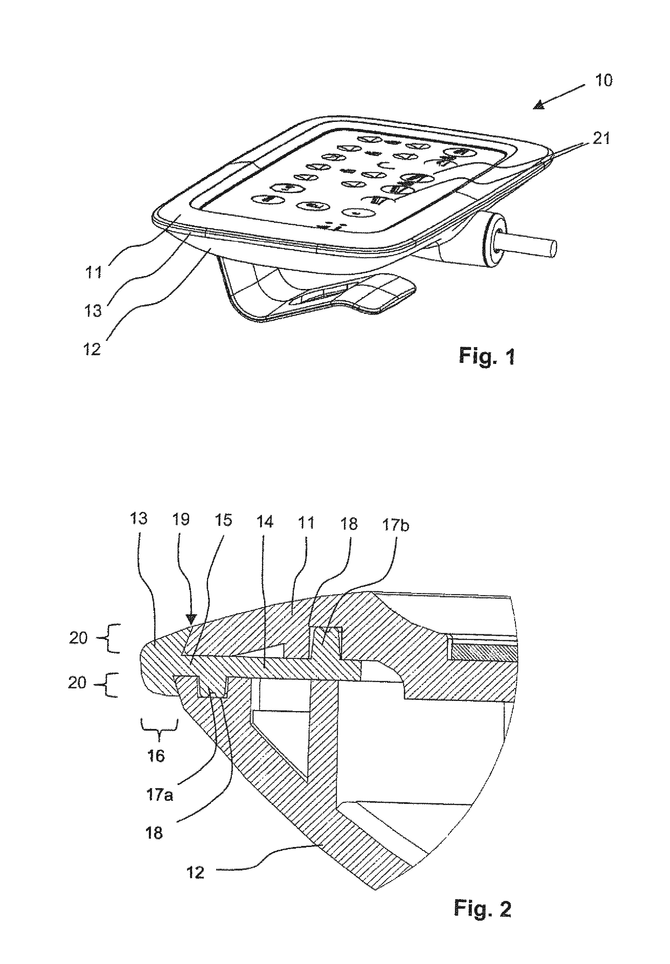

Die in der Figur 1 dargestellte Handbedienung 10 ist eine beispielhafte Einrichtung eines hier nicht näher dargestellten elektromotorischen Möbelantriebs. Die Handbedienung 10 kommt für das Steuern eines Möbels beispielsweise zum Auslösen und Steuern von elektromotorischen Verstellbewegungen einzelner Möbelbauteile relativ zueinander zum Einsatz. Das Möbel ist hier nicht näher dargestellt und ist in beispielhafter Weise als Pflegebett für den Einsatz im häuslichen, stationären oder hospitalen Bereich ausgebildet. Die Handbedienung 10 weist Tastbedienelemente 21 zum Schalten und Steuern von elektrischen Verbrauchern auf. In nicht näher dargestellter Weise sind im Inneren der Handbedienung 10 elektrische Schalter angeordnet, welche mit dem jeweiligen Tastbedienelement 21 mechanisch gekoppelt sind. Die elektrischen Schalter sind als Steuerschalter oder als Lastschalter ausgebildet.

Das Gehäuse der Handbedienung 10 besteht im Wesentlichen aus einem ersten Gehäuseteil 11 und aus einem weiteren Gehäuseteil 12. Das Gehäuse ist vorliegend als Hüllgehäuse ausgebildet; die Gehäuseteile 11, 12 sind dementsprechend halbschalenförmig ausgeformt. Beide Gehäuseteile 11, 12 sind mit ihren Stoßflächen zueinander gewandt ausgerichtet, wobei zwischen den Stoßflächen der Gehäuseteile 11, 12 ein Dichtelement 14 mit einem Stoßabsorber 13 angeordnet ist.

In der Figur 2 ist ein Detailausschnitt des Hüllgehäuses nach Figur 1 im Bereich des Dichtelements 14 und des Stoßabsorbers 13 dargestellt. Das Dichtelement 14 ist zwischen den einander zugewandten Stoßflächen der Gehäuseteile 11, 12 angeordnet. In dieser Ausführung des Dichtelements 14 weist dieses einen Vorsprung 17a auf, welcher in eine Ausnehmung 18 nach Art einer umlaufenden Nut eines Gehäuseteils 11, 12 eingreift. Der Vorsprung wirkt als Dichtvorsprung, um die abdichtende Wirkung des Dichtelements 14 zu erhöhen. Darüber hinaus dient der Vorsprung 17a auch der Festlegung des Dichtelements 14 am Gehäuse. Dieses kann alternativ und/oder zusätzlich auch durch ein Einklemmen des Steges 15 zwischen den beiden Gehäuseteilen 11, 12 erfolgen. Alternativ und wie beispielhaft dargestellt kann das Dichtelement 14 einen weiteren (Dicht-) Vorsprung 17b aufweisen, welcher in eine weitere Ausnehmung 18 der Gehäuseteile 11, 12 eingreift.

Das Dichtelement 14 weist ferner einen nach außen bzw. einen zur äußeren Gehäusekante 19 verlaufenden Steg 15 auf. Alternativ, sofern das Dichtelement 14 keinen (Dicht-) Vorsprung 17a, 17b aufweist, sind Dichtelement 14 und Steg 15 ein einstückiges Formteil. Außerhalb des Hüllgehäuses ist an den Steg 15 ein Fortsatz 16 angeordnet, welcher über die äußere Gehäusekante 19 des Hüllgehäuses hervorspringt. Dabei ist der Fortsatz 16 als Stoßabsorber 13 ausgebildet. Die Querschnittsbreite des Fortsatzes 16 bzw. des Stoßabsorbers 13 ist gemäß dieser Ausführungsform der Handbedienung 10 breiter ausgebildet als die Breite des Steges 15. Somit überragt der Stoßabsorber 13 das Hüllgehäuse ein wenig, wobei das erste Gehäuseteil 11 und das zweite Gehäuseteil 12 mit einer Überdeckung des Stoßabsorbers 13 versehen ist. Die Überdeckung 20 erstreckt sich ein wenig über die äußere Mantelfläche wenigstens eines Gehäuseteils 11, 12.

Gemäß der Ausführung nach Figur 2 weisen die Oberflächen der Gehäuseteile 11, 12 keine planparallelen Abschnitte im Bereich des Stoßabsorbers 13 bzw. im Bereich der Überdeckung 20 auf. Die Oberflächen der Gehäuseteile 11, 12 sind erfindungsgemäß in einem Winkel geneigt ausgeführt, wobei die Neigung einen stumpfen Winkel zu einer gedachten Mittellängsachse des Steges 15 einschließt. Dieser Oberflächenabschnitt kann eben sein oder als Wölbung ausgeführt sein. Bei der Ausführung als Wölbung ist als stumpfes Winkelmaß eine Tangente der Wölbung gegenüber der gedachten Mittellängsachse des Steges 15 anzusehen. Der Vorteil der Abwinkelung liegt darin, dass nun ein Stoß, welcher von außen auf den Stoßabsorber 13 einwirkt, eine gehäusezusammenhaltende Wirkung erzielt, und so die Gehäuseteile 11, 12 nicht auseinander drückt. Die Dichtigkeit des Gehäuses bleibt dadurch im Moment des Stoßes zumindest unverändert oder wird sogar verbessert.

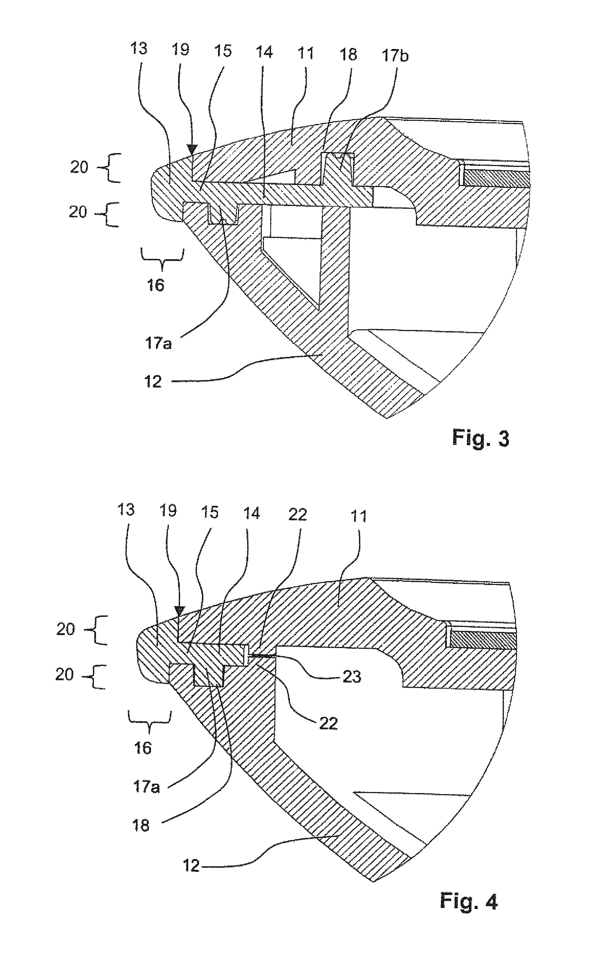

In der Figur 3 ist ein weiteres Ausführungsbeispiel illustriert. Dargestellt ist ein Detailausschnitt eines weiteren als Hüllgehäuse ausgebildeten Gehäuses einer Handbedienung 10 im Bereich des Dichtelements 14 und des Stoßabsorbers 13. Auch hier weist der Stoßabsorber 13 eine Überdeckung 20 auf. Im Unterschied zu dem Ausführungsbeispiel nach Figur 2 ist vorliegend die äußere Gehäusekontur beider Gehäuseteile 11, 12 im Bereich der Überdeckungen 20 planparallel ausgebildet..

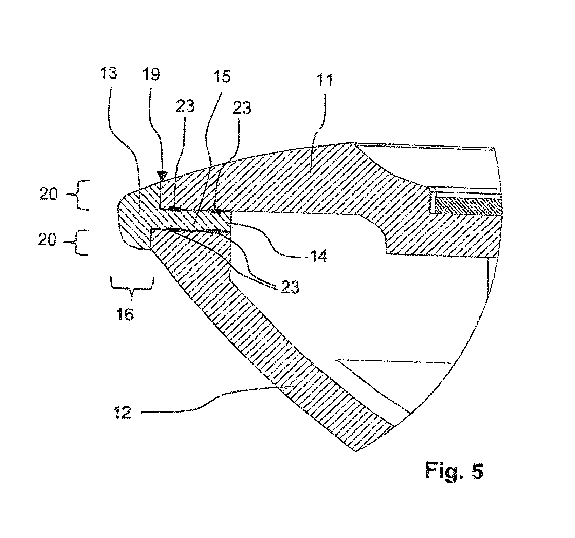

Auch die Figuren 4 und 5 zeigen jeweils ein weiteres Ausführungsbeispiel eines als Hüllgehäuse ausgebildeten Gehäuses einer Handbedienung 10. Bei den Ausführungsbeispielen der Figuren 2 und 3 ist eine Verbindung der Gehäuseteile 11, 12 nicht dargestellt. Sie kann durch verschiedene Verbindungsmittel erfolgen, beispielsweise durch eine Verschraubung, für die entsprechende Schraubdome in die Gehäuseteile 11, 12 eingearbeitet sind, oder mittels einer Verrastung, die über geeignete, ebenfalls in die Gehäuseteile 11, 12 eingearbeitete und ineinander eingreifende Rastmittel, z.B. Rasthaken.

In den Ausführungsbeispielen der Figuren 4 und 5 ist alternativ und/oder zusätzlich eine stoffschlüssige Verbindung zwischen den Gehäuseteilen 11, 12 vorgesehen. Bei beiden Beispielen ist wiederum zwischen einander zugewandten Stoßflächen der Gehäuseteilen 11, 12 ein Dichtelement 14 mit einem Steg 15 angeordnet, das einen außen liegenden Stoßabsorber 13 aufweist. Auch hier weist der Stoßabsorber 13 eine Überdeckung 20 auf, sowie einen Vorsprung 17a, der in eine entsprechende Ausnehmung 18 eingelassen ist.

Bei dem Beispiel der Figur 4 ist benachbart zu den Stoßflächen in jedem der Gehäuseteile 11, 12 je ein Gehäusesteg 22 ausgebildet, bevorzugt vollständig und geschlossen umlaufend. Die beiden Gehäusestege 22 sind an ihrer zueinander weisenden Stirnfläche durch eine Ultraschallschweißnaht 23 miteinander verbunden. Dazu kann an einem oder an beiden Gehäusestegen 22 ein hervorstehender Nahtvorsprung ausgeformt sein, an dem sich durch über die Gehäuseteile 11, 12 eingebrachte Ultraschallwellen die Ultraschallschweißnaht 23 ausbildet. Die Ultraschallschweißnaht 23 verbindet die Gehäuseteile 11, 12 und hat gleichzeitig abdichtende Wirkung.

Das Dichtelement 14 dieses Ausführungsbeispiels entspricht in seiner Funktion dem der Ausführungsbeispiele der Figuren 2 und 3, wobei jedoch aufgrund der Ultraschallschweißnaht 23 die abdichtende Funktion gegenüber der Funktion des Kantenschutzes zurücktritt. Entsprechend dienen der Vorsprung 17a und die Ausnehmung 18 hier ebenso eher der Fixierung des Dichtelements 14 und nicht der Abdichtung. Falls jedoch die Ultraschallschweißnaht 23 nicht vollumfänglich ausgeführt ist oder produktionsbedingt kleine Undichtigkeiten aufweist, wird auch bei diesem Ausführungsbeispiel unterstützend die abdichtende Funktion des Dichtelements 14 bedeutsam.

Bei dem Ausführungsbeispiel gemäß Figur 5 erfolgt eine Verbindung der beiden Gehäuseteile 11, 12 ebenfalls über Ultraschallschweißnähte 23. Die Gehäuseteile 11, 12 sind hier über das Dichtelement 14 miteinander verbunden, indem mindestens eine Ultraschallschweißnaht 23 (hier beispielhaft zwei) den Steg 15 mit dem ersten Gehäuseteil 11 verbindet und mindestens eine weitere Ultraschallschweißnaht 23 (hier beispielhaft wiederum zwei) den Steg 15 mit dem zweiten Gehäuseteil 12 verbindet. Das Dichtelement 14 kann in diesem Fall vorteilhaft aus zwei verschiedenen Materialien bestehen, die in einem 2-Komponenten-Spritzgießverfahren zu einem integralen Element verarbeitet werden. Der Steg 15 kann beispielsweise aus einem härteren Kunststoff gefertigt sein, beispielsweise demselben Material, aus dem auch die Gehäuseteile 11, 12 gefertigt sind. An den Steg 15 ist dann der aus einem weicheren Material bestehende Stoßabsorber 13 angespritzt.

Alternativ hierzu ist nur die Oberfläche des Steges 15 benachbart zur Ultraschallschweißnaht 23 aus einem härteren Kunststoff gefertigt, während der Kern des Steges 15 sowie das Dichtelement 14 als Weichkomponente eines 2-Komponenten-Spritzgießteils ausgebildet ist.

### Bezugszeichenliste

- 10: Handbedienung
- 11: erstes Gehäuseteil
- 12: zweites Gehäuseteil
- 13: Stoßabsorber
- 14: Dichtelement
- 15: Steg
- 16: Fortsatz
- 17a: Vorsprung
- 17b: weiterer Vorsprung
- 18: Ausnehmung
- 19: äußere Gehäusekante
- 20: Überdeckung
- 21: Tastbedienelemente
- 22: Gehäusesteg
- 23: Schweißnaht

## Patentansprüche

1. Gehäuse zur Aufnahme von mechanischen und/oder elektrischen Komponenten eines elektromotorischen Möbelantriebs mit mindestens zwei Gehäuseteilen (11, 12) und einem Dichtelement (14), welches zwischen einander zugewandten Stoßflächen der mindestens zwei Gehäuseteile (11, 12) angeordnet ist, **dadurch gekennzeichnet, dass** das Dichtelement (14) einen Steg (15) aufweist, welcher zwischen den Stoßflächen nach außen zu einer äußeren Gehäusekante (19) geführt ist und außerhalb des Gehäuses einen Fortsatz (16) aufweist, welcher als Stoßabsorber (13) ausgebildet ist

2. Gehäuse nach Anspruch 1, **dadurch gekennzeichnet, dass** das Gehäuse als Hüllgehäuse ausgebildet ist.

3. Gehäuse nach Anspruch 1 bis 2, **dadurch gekennzeichnet, dass** das Gehäuse Teil einer Handbedienung (10) mit Tastbedienelementen (21) für einen elektromotorischen Möbelantrieb ist.

4. Gehäuse nach einem der Ansprüche 1 bis 3, **dadurch gekennzeichnet, dass** das Dichtelement (14), der Steg (15) und der Fortsatz (16) ein einstückiges Formteil bilden.

5. Gehäuse nach wenigstens einem der Ansprüche 1 bis 4, **dadurch gekennzeichnet, dass** der Fortsatz (16) bzw. der Stoßabsorber (13) im Wesentlichen dieselbe Querschnittsbreite wie die des Stegs (15) aufweist.

6. Gehäuse nach wenigstens einem der Ansprüche 1 bis 4, **dadurch gekennzeichnet, dass** der Fortsatz (16) bzw. der Stoßabsorber (13) breiter als die Querschnittsbreite des Steges (15) ausgebildet ist.

7. Gehäuse nach Anspruch 6, **dadurch gekennzeichnet, dass** sich der Fortsatz (16) bzw. der Stoßabsorber (13) über eine Überdeckung (20) über einen Teil des Gehäusebauteils (11, 12) erstreckt.

8. Gehäuse nach Anspruch 7, **dadurch gekennzeichnet, dass** die Gehäuseteile (11, 12) im Bereich der Überdeckung (20) geneigt zueinander ausgebildete Oberflächen aufweisen, wobei die Neigung einen stumpfen Winkel zu einer gedachten Mittellängsachse des Steges (15) einschließt.

9. Gehäuse nach wenigstens einem der vorstehenden Ansprüche, **dadurch gekennzeichnet, dass** der Fortsatz (16) bzw. der Stoßabsorber (13), der Steg (15) und das Dichtelement (14) aus einem Elastomer gefertigt sind.

10. Gehäuse nach wenigstens einem der vorstehenden Ansprüche, **dadurch gekennzeichnet, dass** das Dichtelement (14) Vorsprünge (17a, 17b) aufweist, welche in Ausnehmungen (18) des jeweiligen Gehäuseteils (11, 12) eingreifen.

11. Gehäuse nach wenigstens einem der vorstehenden Ansprüche, **dadurch gekennzeichnet, dass** die beiden Gehäuseteilen (11, 12) miteinander stoffschlüssig verbunden sind.

12. Gehäuse nach Anspruch 11, **dadurch gekennzeichnet, dass** die beiden Gehäuseteile (11, 12) durch mindestens eine Ultraschallschweißnaht (23) miteinander verbunden sind.

13. Gehäuse nach Anspruch 12, **dadurch gekennzeichnet, dass** die Ultraschallschweißnaht (23) entlang von Gehäusestegen (22) geführt ist, die in den Gehäuseteile (11, 12) benachbart zu den Stoßflächen, zwischen denen der Steg (15) angeordnet ist, ausgebildet sind.

14. Gehäuse nach Anspruch 13, **dadurch gekennzeichnet, dass** die beiden Gehäuseteile (11, 12) über den Steg (15) miteinander verbunden sind, wobei jedes der beiden Gehäuseteile (11, 12) mit mindestens je einer Ultraschallschweißnaht (23) mit dem Steg (15) verbunden ist.
